# EUROPEAN PATENT SPECIFICATION

(11) **EP 3 012 862 B1**
(45) Date of publication and mention of the grant of the patent: **14.06.2017**
(21) Application number: 15188974.8
(22) Date of filing: 08.10.2015
(51) Int. Cl.: H01L 23/498, H01L 21/48

(54) **MOLDING COMPOUND SUPPORTED RDL FOR IC PACKAGE**
FORMVERBUNDSTOFFGESTÜTZTE RDL FÜR GEHÄUSE EINER INTEGRIERTEN SCHALTUNG
RDL SUPPORTÉ PAR COMPOSÉ DE MOULAGE POUR UN BOÎTIER DE CI

(30) Priority: 24.10.2014 US 201414522760; 03.12.2014 US 201414559696; 16.01.2015 US 201514598341
(43) Date of publication of application: 27.04.2016
(73) Proprietor: Hu, Dyi-Chung, 310 Hsinchu (TW)
(72) Inventor: Hu, Dyi-Chung, 310 Hsinchu (TW)
(74) Representative: Stüven, Ralf

(56) References cited:
- WO-A1-2008/101102
- US-A1- 2012 153 445

## Description

### BACKGROUND

### Technical Field

The present invention relates to a redistribution layer (RDL) for IC package, especially relates to an RDL supported by molding compound.

### Description of Related Art

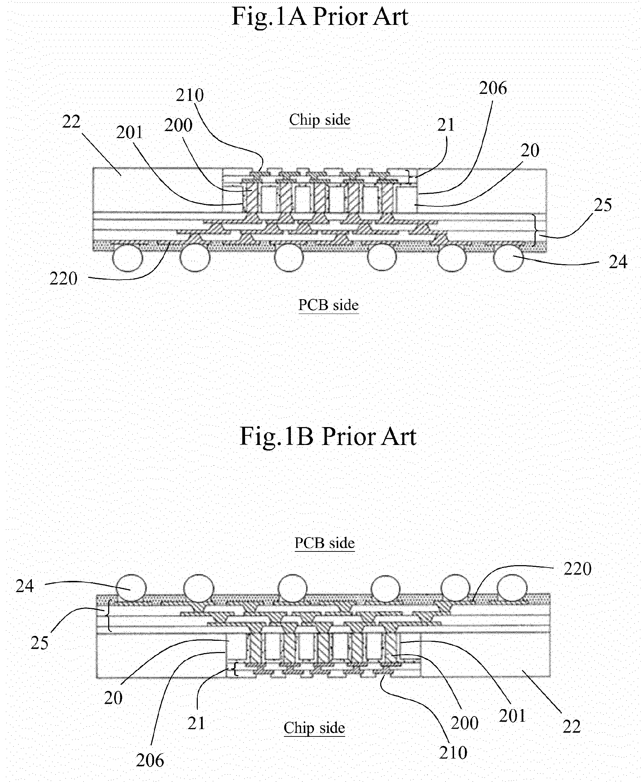

Figs.1A-1B show a prior art substrate for IC package
Fig.1A shows a prior art substrate for IC package
Fig.1A shows a prior art substrate for IC package disclosed in US 2014/0102777 A1 which has an embedded silicon interposer 20. The silicon interposer 20 has four lateral sides 206. A molding compound 22 wraps the silicon interposer 20 around the four lateral sides 206. A plurality of via metals 200 is made through the silicon interposer 20. An insulation liner 201 is made between the through via 200 and the silicon interposer 20 for an electrical insulation there-between. A top redistribution layer 21 is made on a top surface of the silicon interposer 20 with a plurality of metal pads 210 exposed on top. The plurality of metal pads 210 on top is provided for accommodating an IC chip (not shown) to mount. A circuit built-up layer 25 is made on bottom of the silicon interposer 20 with a plurality of metal pads 220 configured on bottom. A plurality of solder balls 24 is configured and each solder ball 24 is configured on a bottom surface of a corresponding bottom pad 220.
Fig.1B shows a reversed view of Fig.1A. Fig.1B is made to present the prior art of Fig.1A in a position similar to a package substrate of the present invention to facilitate a comparison there between. Fig.1B shows an up-down view of Fig.1A. The top solder ball 24 is configured for mounting the package substrate onto a mother board (not shown). The bottom pad 210 is configured for a chip or chips to mount. Another prior art package is described in US2012153445.

A simpler package substrate and simpler fabricating process to reduce the cost and advance the reliability for IC package have been studying for a long time in the semiconductor industry. The present invention provides molding compound supported redistribution layer structures for integrated circuits according to independent claims 1 and 14.

### BRIEF DESCRIPTION OF THE DRAWINGS

Figs. 1A-1B show a prior art substrate for IC package
Figs. 2A-2L and 3A-3C show a process for manufacturing a structure according to the present invention.
Fig. 3D is a first embodiment of the present invention.
Fig. 3E is a second embodiment of the present invention.
Fig. 3F shows an IC chip mounted on bottom of the first embodiment of Fig. 3D

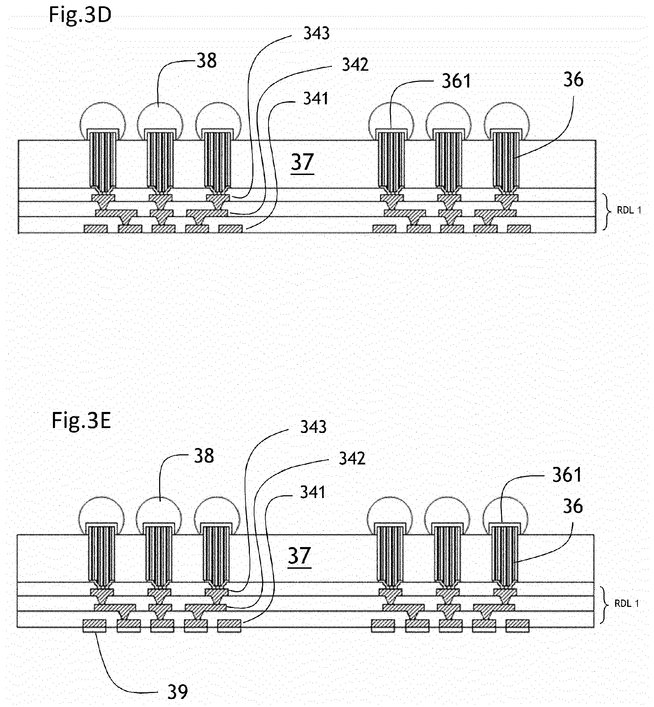

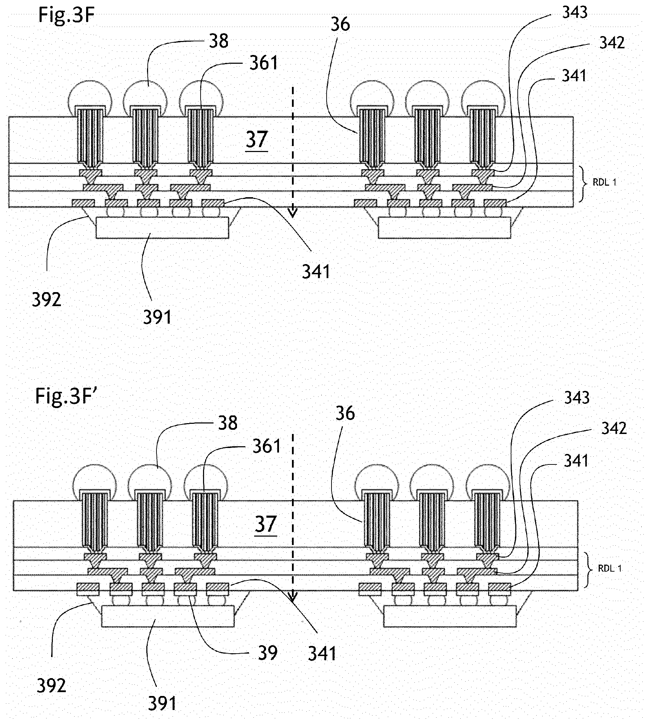

Fig. 3F' shows an IC chip mounted on bottom of the second embodiment of Fig. 3E

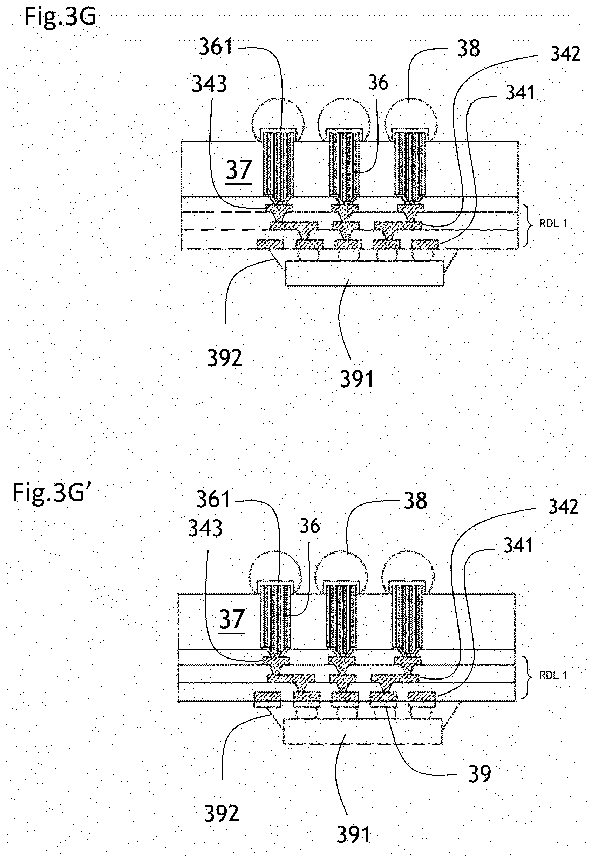

Fig. 3G shows an IC package unit obtained through singulating the product of Fig. 3F.
Fig. 3G' shows an IC package unit obtained through singulating the product of Fig. 3F'

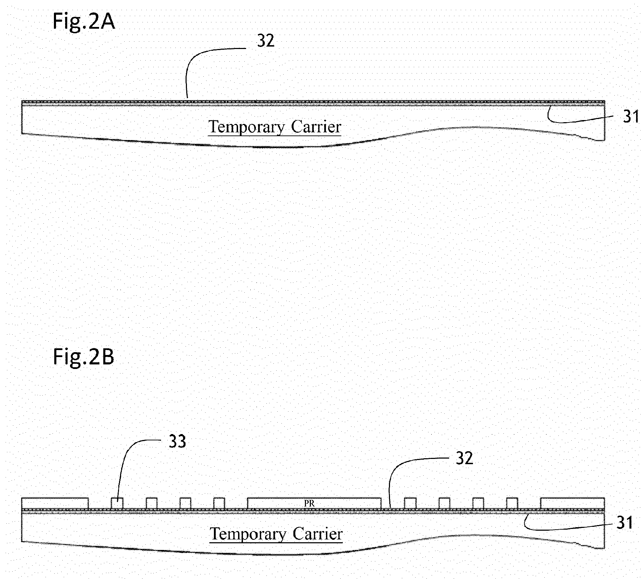

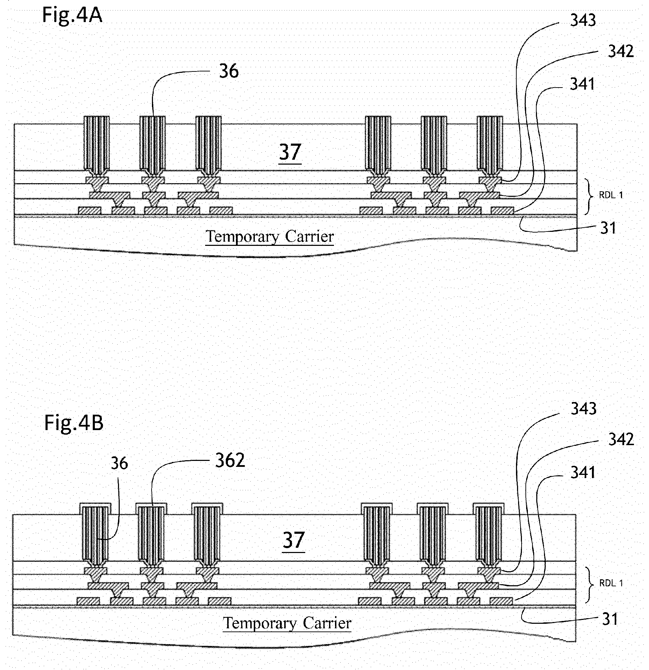

Figs. 2A-2L and 4A-4C show a process for manufacturing a structure according to the present invention.

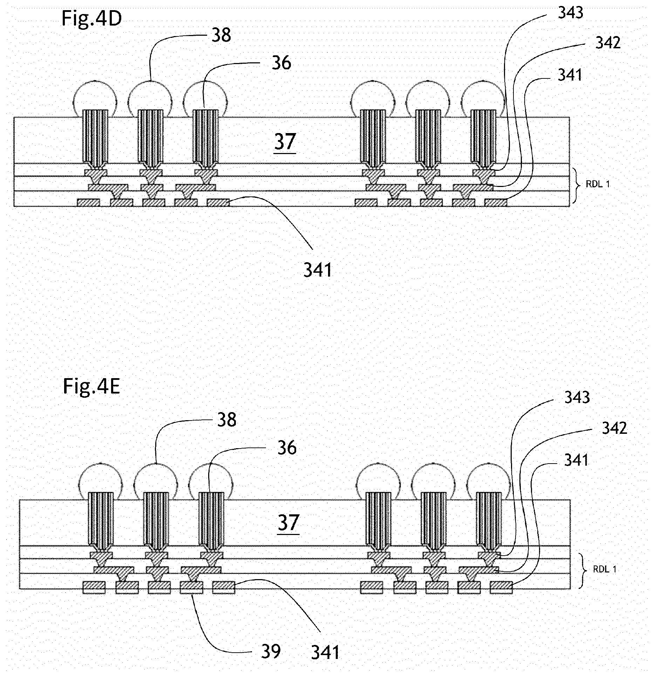

Fig. 4D is a third embodiment of the present invention.
Fig. 4E is a fourth embodiment of the present invention.

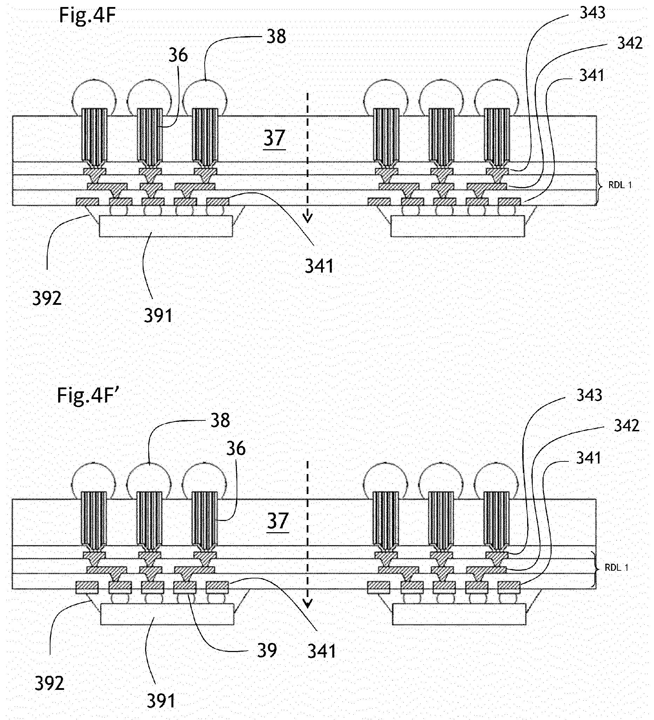

Fig. 4F shows an IC chip mounted on bottom of Fig. 4D
Fig. 4F' shows an IC chip mounted on bottom of Fig. 4E

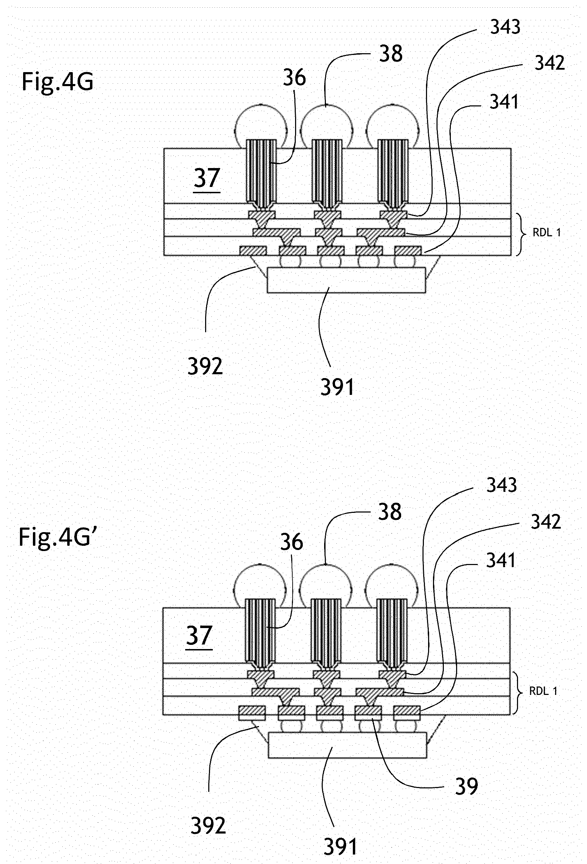

Fig. 4G shows an IC package unit obtained through singulating the product of Fig. 4F.
Fig. 4G' shows an IC package unit obtained through singulating the product of Fig. 4F'

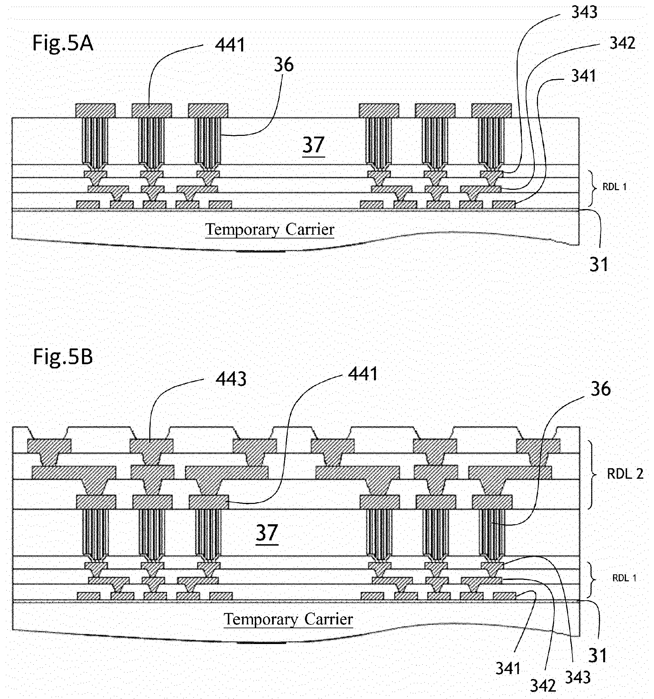

Figs. 2A-2L and 5A-5C, shows a process for manufacturing a structure according to the present invention.

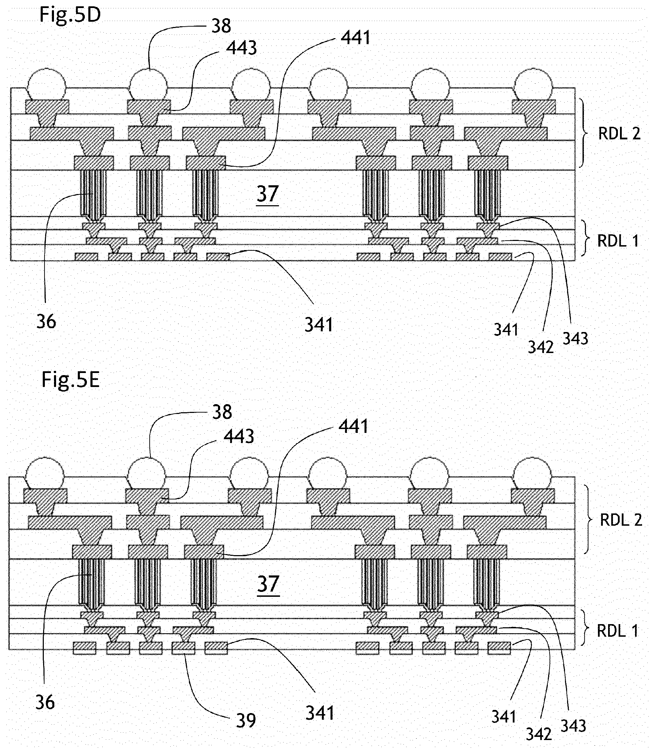

Fig. 5D is a fifth embodiment of the present invention.
Fig. 5E is a sixth embodiment of the present invention.

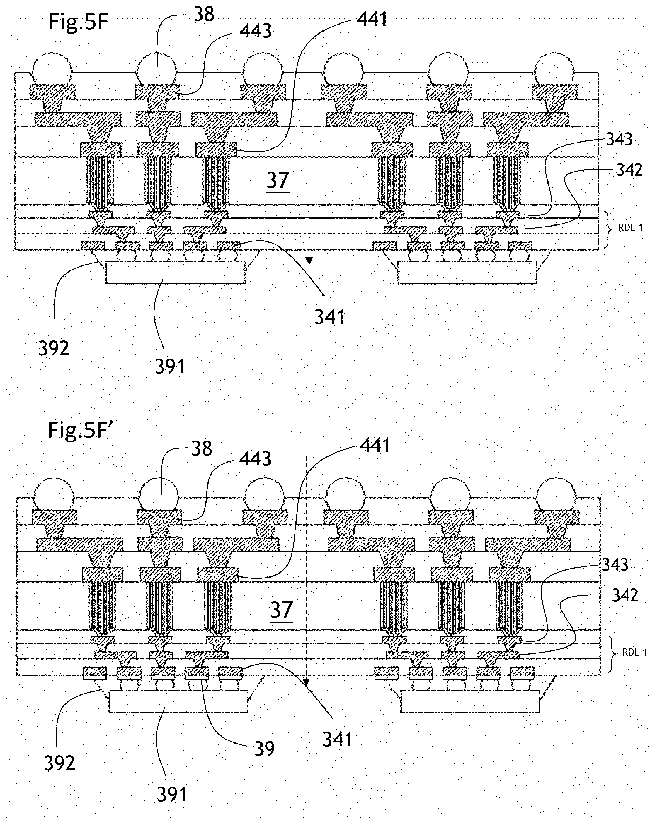

Fig. 5F shows an IC chip mounted on bottom of Fig. 5D
Fig. 5F' shows an IC chip mounted on bottom of Fig. 5E

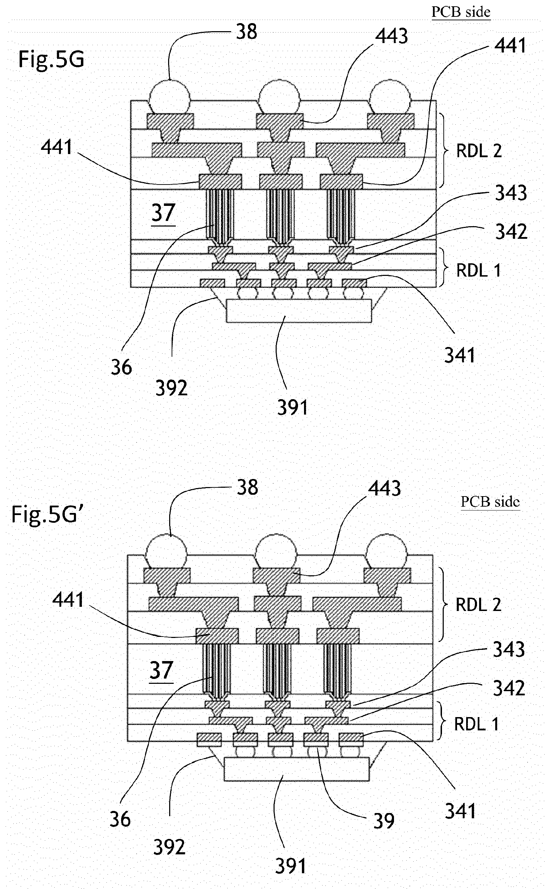

Fig. 5G shows an IC package unit obtained through singulating the product of Fig. 5F.
Fig. 5G' shows an IC package unit obtained through singulating the product of Fig. 5F'

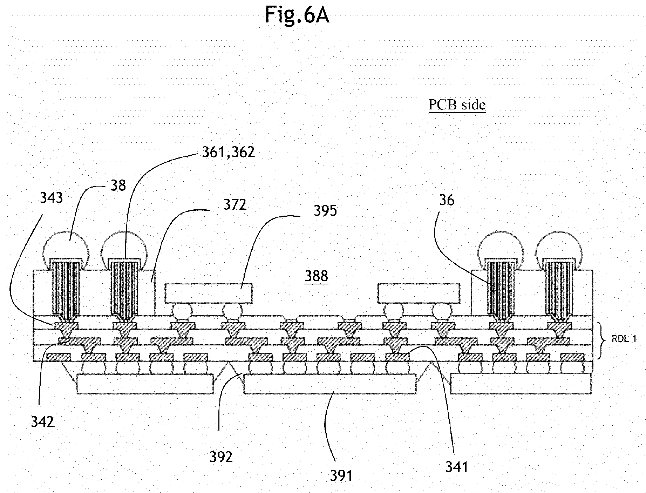

Figs. 6A~6B is a seventh embodiment of the present invention.

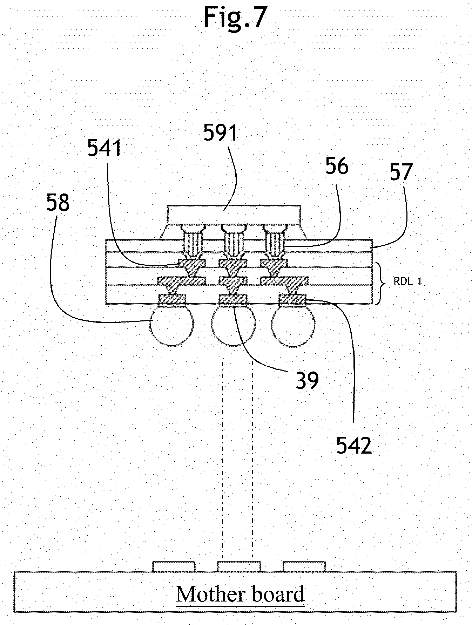

Fig. 7 shows an eighth embodiment according to the present invention.

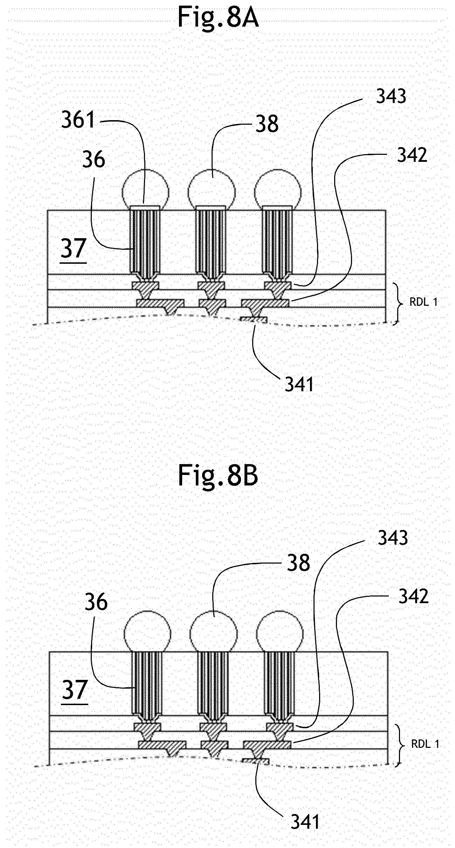

Figs. 8A-8B shows modified embodiments according to the present invention.

### DETAILED DESCRIPTION OF THE INVENTION

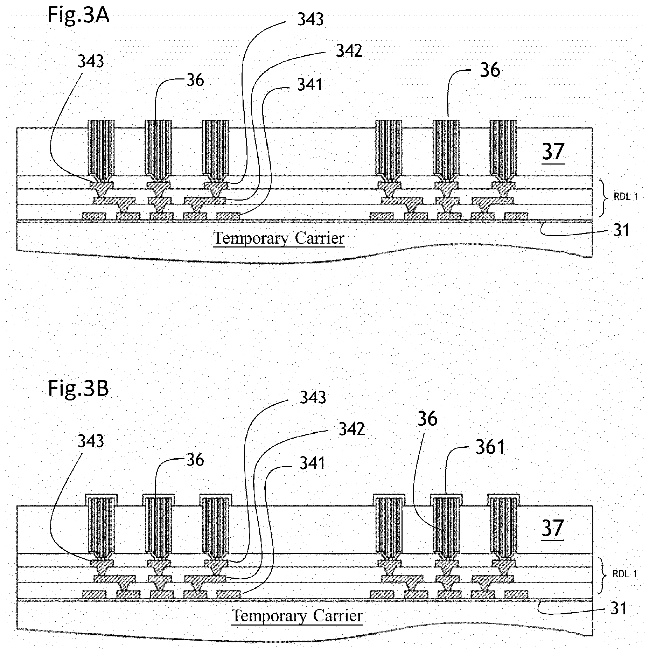

Figs. 2A-2L and 3A-3C show a manufacturing process according to the present invention. Fig. 3D is a first embodiment of the present invention; and Fig. 3E is a second embodiment of the present invention.

A molding compound supported RDL for IC package is fabricated, includes the following steps:
Fig. 2A shows: preparing a temporary carrier; applying a release layer 31 on a top surface of the temporary carrier; and applying a bottom seed layer 32 on a top surface of the release layer 31.
Fig. 2B shows: applying a patterned photo resist (PR) 33 on a top surface of the bottom seed layer 32.

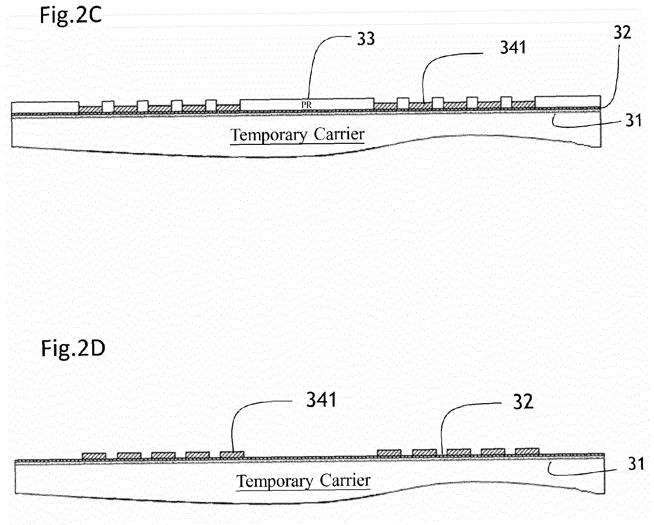

Fig. 2C shows: forming a patterned first bottom pad 341.
Fig. 2D shows: stripping the photo resist 33.

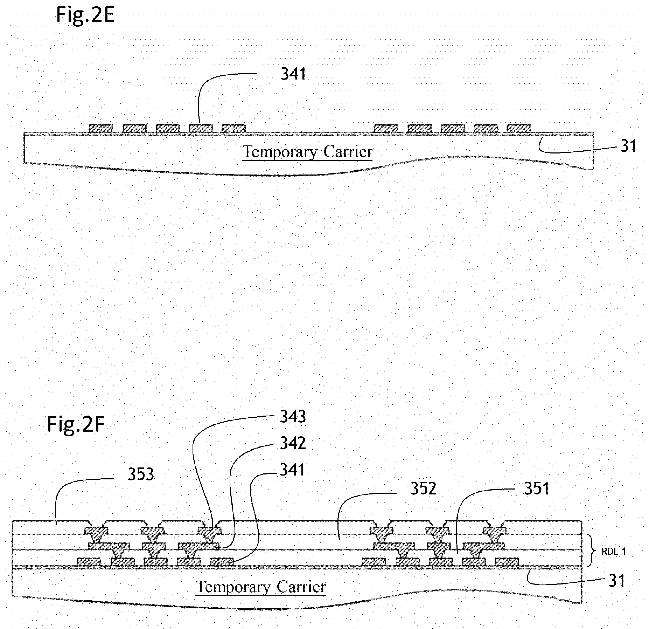

Fig. 2E shows: stripping the bottom seed layer 32 between the first bottom pads 341.
Fig. 2F shows: forming a bottom RDL (RDL 1, RDL = redistribution layer) using the first bottom pad 341 as a starting point; forming a plurality of first top pads 343 on a top surface of the bottom RDL (RDL 1), wherein at least one circuit layer 342 is made between the first bottom pads 341 and the first top pads 343. A first top dielectric layer 353 is formed on a top surface of the first top pads 343 and a plurality of openings is made to expose a top of each first top pad 343. The first bottom pads 341, circuit layer 342, and the first top pads 343 are embedded in the dielectric layers 351, 352, 353; forming a first top dielectric layer 353 with a plurality of openings, each opening exposing a top of a corresponding first top pad 343;

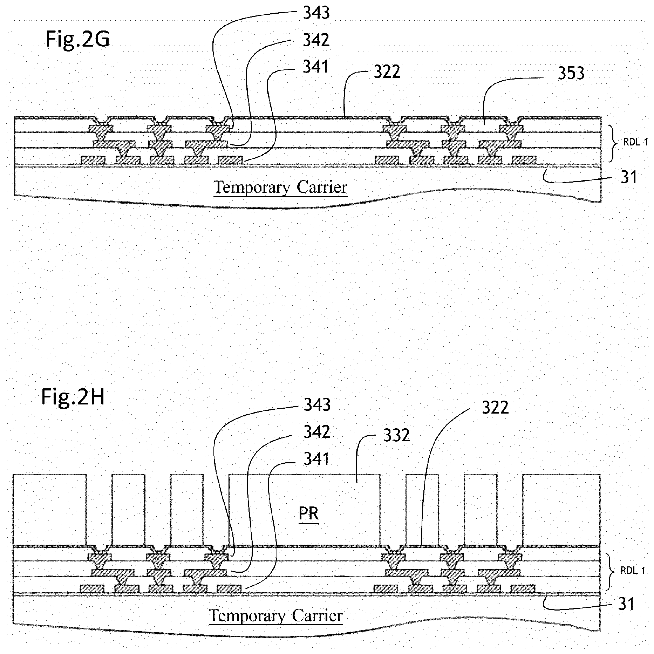

Fig. 2G shows: applying a top seed layer 322 on a top surface of the first top dielectric layer 353 and the first top pads 343;
Fig. 2H shows: forming a patterned photo resist (PR) 332 on a top surface of the top seed layer 322;

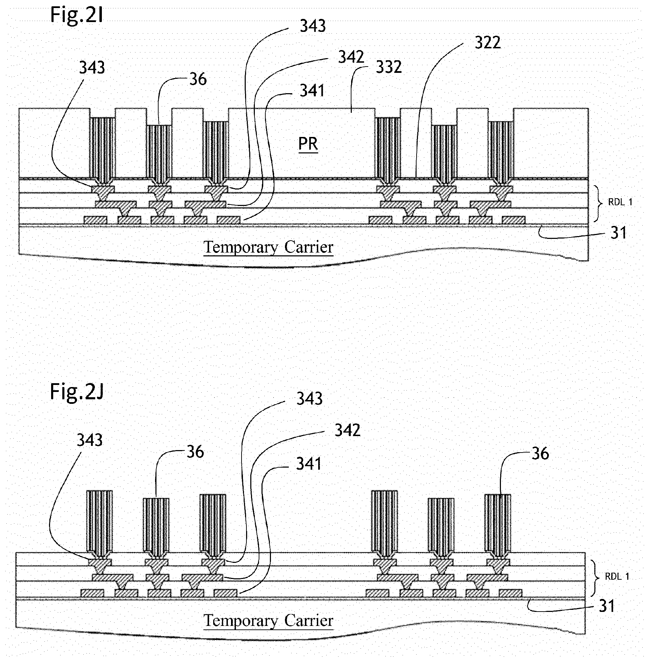

Fig. 2I shows: forming a plurality of copper pillars 36, each is formed on a top surface of a corresponding first top pad 343;
Fig. 2J show: stripping the photo resist 332 and leaving the copper pillar 36 exposed;
   stripping the top seed layer 322 between copper pillars 36;
   revealing the plurality of copper pillars 36;

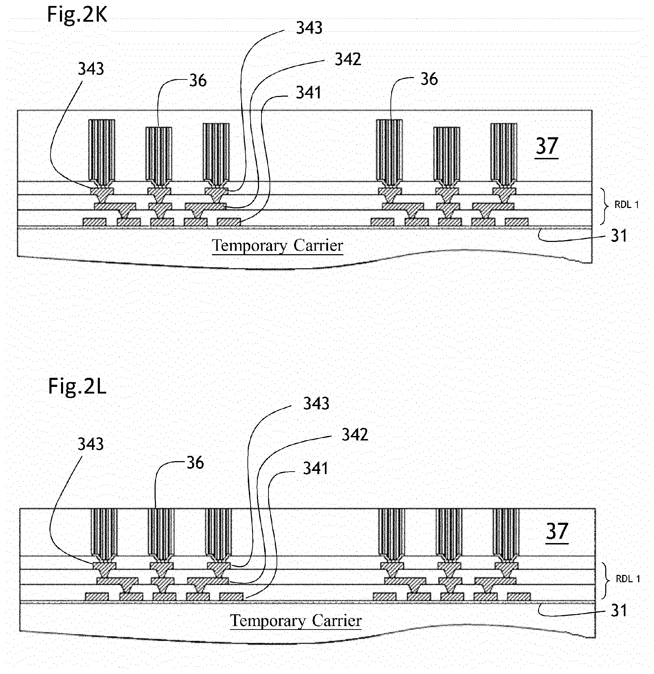

Fig. 2K shows: applying a molding compound 37 to encapsulate the plurality of copper pillars 36;
Fig. 2L shows: thinning from top of the molding compound 37; and
   revealing a top surface of each copper pillar 36.
Fig. 3A shows: removing portion of the molding compound 37 from top, revealing a top end of each copper pillar 36;
Fig. 3B shows: forming a protection layer 361, such as an Electroless Nickel/Electroless Palladium/Immersion Gold (ENEPIG), on each revealed top of the copper pillar 36;

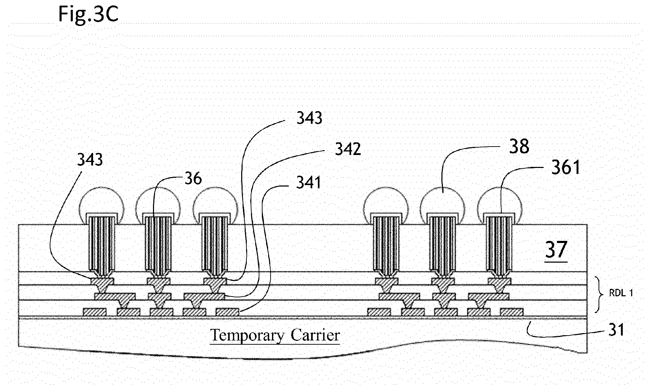

Fig. 3C shows: planting a plurality of solder balls 38, each is planted on a top surface of a corresponding protection layer 361 which brackets a top end of a corresponding copper pillar 36;
Fig. 3D shows: removing the temporary carrier and the release layer 31; and removing the bottom seed layer 32 from bottom of each first bottom pad 341.

Fig. 3D shows a molding compound 37 wrapping a plurality of copper pillars 36, a protection layer 361 is configured on a top surface of a corresponding copper pillar 36; a solder ball 38 is configured on top of each protection layer 361; a bottom RDL (RDL 1) is made on bottom of the molding compound 37.

Fig. 3E shows: forming a bottom protection layer 39 on a bottom surface of a corresponding first bottom pad 341. The protection layer 39, 361 can be ENEPIG or equivalent. The protection layer 39, 361 prevents oxidation of the exposed end of the copper pillar 36 before next step. Fig. 3E shows a molding compound 37 wrapping a plurality of copper pillars 36, a protection layer 361 is configured on a top surface of a corresponding copper pillar 36; a solder ball 38 is configured on top of each protection layer 361; a bottom RDL (RDL 1) is made on bottom of the molding compound 37; a bottom protection layer 39 is made on a bottom surface of a corresponding first bottom pad 341.

Fig. 3F shows an IC chip 391 mounted on bottom of a product shown in Fig. 3D

Fig. 3F shows a chip 391 mounted on bottom of Fig. 3D; the chip 391 is electrically coupled to the first bottom pad 341 through a plurality of solder balls. An under fill 392 can be made between the chip 391 and the first bottom pad 341.

Fig. 3F' shows an IC chip 391 mounted on bottom of a product shown in Fig. 3E
Fig. 3F' shows a chip 391 mounted on bottom of a product shown in Fig. 3E; the chip 391 is electrically coupled to the bottom protection layer 39 through a plurality of solder balls. An under fill 392 can be made between the chip 391 and the bottom protection layer 39.

Fig. 3G shows an IC package unit obtained through singulating the product of Fig. 3F.
Fig. 3G shows an IC package based on the molding compound supported RDL of the first embodiment of Fig. 3F according to the present invention. The package has a redistribution layer (RDL1). The redistribution layer (RDL1) has a plurality of bottom pads 341 and a plurality of top pads 343. A density of the bottom pads 341 is higher than a density of the top pads 343. A plurality of copper pillars 36 is formed, each copper pillar 36 is configured on a top surface of a corresponding top pad 343. A top surface of each copper pillar 36 is exposed and adaptive for electrically coupled to a mother board (not shown) in a later step. A chip 391 is configured on a bottom side of the bottom pad 343.
Fig. 3G' shows an IC package unit obtained through singulating the product of Fig. 3F'
Fig. 3G' shows an IC package based on the molding compound supported RDL of the second embodiment of Fig. 3F' according to the present invention. The difference between Fig. 3G and 3G' is that Fig. 3G' has a protection coating 39 formed on a bottom surface of the bottom pads 341.

Figs. 2A-2L and 4A-4C show a manufacturing process according to the present invention. Fig. 4D is a third embodiment of the present invention. Fig. 4E is a fourth embodiment of the present invention.
The manufacturing process of Figs. 2A-2L is the same as described in previous paragraph and omitted here for simplification.
Fig. 4A shows: removing portion of the molding compound 37 from top, revealing a top end of each copper pillar 36;
Fig. 4B shows: forming a protection layer 362, such as an Organic Solderability Preservatives (OSP), on each revealed top of the copper pillar 36. The protection layer 362 prevents oxidation of the exposed end of the copper pillar 36 before next step.

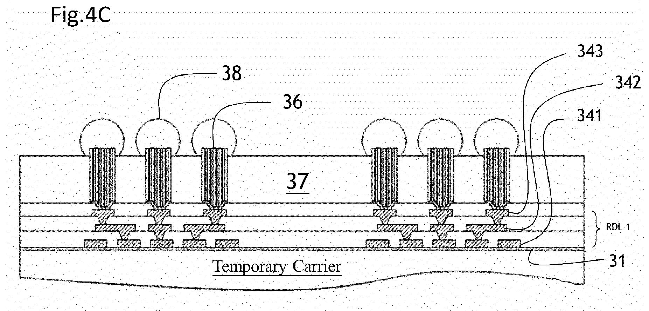

Fig. 4C shows: planting a plurality of solder balls 38, each is planted on a top surface of a corresponding protection layer 362, however OSP is cleaned out by soldering flux and heat; therefore, the solder balls 38 can be seen planted directly on a top surface of a corresponding copper pillar 36.

Fig. 4D shows: removing the temporary carrier; and removing the seed layer 32 and the release layer 31 from bottom of each first bottom pad 341.

Fig. 4E shows: forming a bottom protection layer 39 on a bottom surface of a corresponding first bottom pad 341. The protection layer 39 is ENEPIG. Fig. 4E shows a molding compound 37 wrapping a plurality of copper pillars 36; a solder ball 38 is configured on a top surface of a corresponding copper pillar 36; a bottom RDL (RDL 1) is made on bottom of the molding compound 37; a bottom protection layer 39 is made on a bottom surface of a corresponding first bottom pad 341.

Fig. 4F shows an IC chip 391 mounted on bottom of a product shown in Fig. 4D

Fig. 4F shows an IC chip 391 mounted on bottom of a product shown in Fig. 4D; the chip 391 is electrically coupled to the first bottom pad 341 through a plurality of solder balls. An under fill 392 can be made between the chip 391 and the first bottom pad 341.

Fig. 4F' shows an IC chip 391 mounted on bottom of a product shown in Fig. 4E

Fig. 4F' shows an IC chip 391 mounted on bottom of a product shown in Fig. 4E; the chip 391 is electrically coupled to the bottom protection layer 39 through a plurality of solder balls. An under fill 392 can be made between the chip 391 and the bottom protection layer 39.

Fig. 4G shows an IC package unit obtained through singulating the product of Fig. 4F.

Fig. 4G shows an IC package which is a package based on the molding compound supported RDL of the third embodiment according to the present invention. The difference between Fig. 3G and Fig. 4G is that Fig. 3G has a protection layer 361 to protect a top surface of a corresponding copper pillar 36. Fig. 4G does not have such a protection layer 361.

Fig. 4G' shows an IC package unit obtained through singulating the product of Fig. 4F'

Fig. 4G' shows an IC package which is a package based on the molding compound supported RDL of the fourth embodiment according to the present invention. The difference between Fig. 4G and Fig. 4G' is that Fig. 4G' has a protection layer 39 configured on a bottom surface of a corresponding bottom pad 341.

Figs. 2A-2L and 5A-5C, shows a manufacturing process according to the present invention.

Fig. 5D is a fifth embodiment of the present invention. Fig. 5E is a sixth embodiment of the present invention.

The manufacturing process of Figs. 2A-2L is the same as described in previous paragraph and omitted here for simplification.

Fig. 5A shows: forming a second bottom pad 441 on a top surface of a corresponding copper pillar 36;

Fig. 5B shows: forming a top RDL (RDL 2) on a top surface of the molding compound 37; forming a plurality of second top pads 443 on a top surface of the top RDL (RDL 2);

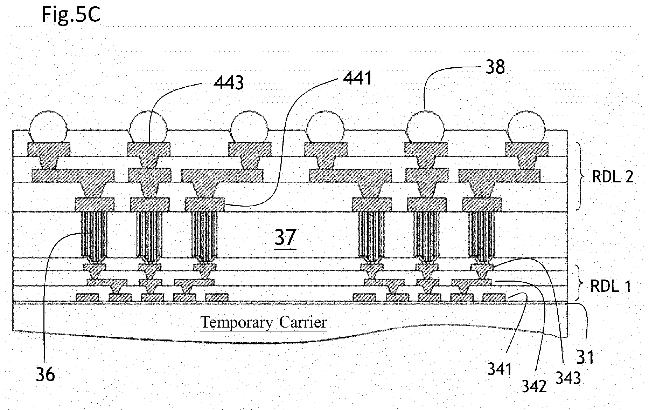

Fig. 5C shows: planting a plurality of solder balls 38, each is planted on a top surface of a corresponding second top pad 443;

Fig. 5D shows: removing the temporary carrier; and removing the bottom seed layer 32 and the release layer 31 from bottom of each first bottom pad 341.

Fig. 5E shows: forming a bottom protection layer 39 on a bottom surface of a corresponding first bottom pad 341.

Fig. 5F shows an IC chip 391 mounted on bottom of a product shown in Fig. 5D

Fig. 5F shows an IC chip 391 mounted on bottom of a product shown in Fig. 5D; the chip 391 is electrically coupled to the first bottom pad 341 through a plurality of solder balls. An under fill 392 can be made between the chip 391 and the first bottom pad 341.

Fig. 5F' shows an IC chip 391 mounted on bottom of a product shown in Fig. 5E

Fig. 5F' shows an IC chip 391 mounted on bottom of a product shown in Fig. 5E; the chip 391 is electrically coupled to the bottom protection layer 39 through a plurality of solder balls. An under fill 392 can be made between the chip 391 and the bottom protection layer 39.

Fig. 5G shows an IC package unit obtained through singulating the product of Fig. 5F.

Fig. 5G shows an IC package which is a package based on the molding compound supported RDL of the fifth embodiment according to the present invention. Fig. 5G shows that each copper pillar 36 has a top surface coplanar with a top surface of the molding compound 37. A second redistribution layer (RDL2) formed on a top end of the copper pillars 36.

Fig. 5G' shows an IC package unit obtained through singulating the product of Fig. 5F'.

Fig. 5G' shows an IC package which is a package based on the molding compound supported RDL of the sixth embodiment according to the present invention. The difference between Fig. 5G' and Fig. 5G is that Fig. 5G' has a protection layer 39 formed on a bottom surface of a corresponding bottom pads 341.

Fig.6A-6B is a seventh embodiment of the present invention.
Fig. 6A shows a plurality of copper pillars 36 are formed only four sides on a top surface of the redistribution layer (RDL1). A square wall molding compound 372 is formed to encapsulate the plurality of copper pillars 36 and a central cavity 388 is formed in the center of the square wall molding compound 372. The central cavity 388 is reserved and adaptive for one or more electronic devices to mount. Two capacitors 395 are configured in the central cavity 388 as an example only.

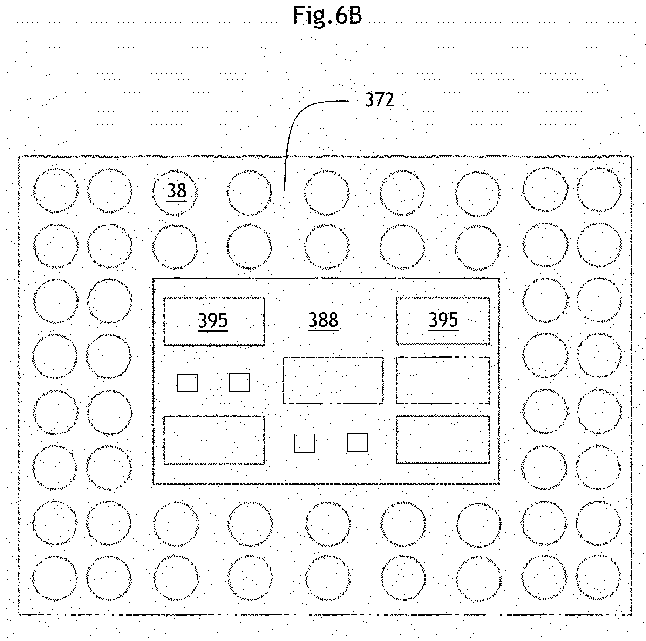

Fig. 6B shows a top view of Fig. 6A. Fig. 6B shows two capacitors 395 and additional electronic devices are configured in the central cavity 388 as an example only. The central cavity 388 is surrounded by the square wall molding compound 372.
The passive elements, such as the capacitors 395, are configured near the bottom chip 391; the close distance shortens the circuit trace therebetween so that simultaneously switching noise (SSN) can be reduced to a minimum at a first stage when power is on for the IC package.

Fig. 7 shows an eighth embodiment according to the present invention.
Fig. 7 is a chip package similar to Fig. 3G. The difference is that the plurality of copper pillars 36 of Fig. 3G is made on PCB side while the plurality of copper pillars 56 of Fig. 7 is made on chip side. That is to say, an open side of the copper pillars 56 of Fig. 7 is made adaptive for a chip or chips to mount thereon.
Fig. 7 shows a molding compound supported RDL for IC package. The redistribution layer (RDL1) has a plurality of bottom pads 542 and a plurality of top pads 541; wherein a density of the top pads 541 is higher than the density of the bottom pads 542. A molding compound 57 is configured on a top surface of the RDL1. Each bottom pad 542 has a protection layer 39 on bottom. A plurality of solder balls 58 are prepared, each one is arranged on a bottom surface of a corresponding protection layer 39, so that the chip package can be mounted on a mother board via the solder balls 58. A plurality of copper pillars 56 is formed on a top side of the redistribution layer ((RDL1). A bottom end of each copper pillar 56 is configured on a top surface of a corresponding top pad 541. A top side of the copper pillars 56 is made adaptive for being electrically coupled to a chip or chips. A chip 591 is configured on a top of the copper pillar 56 as an example only shown in Fig. 7.

Figs. 8A-8B shows modified embodiments according to the present invention.
Fig. 8A is a modified embodiment of Figs. 3G, 3G'
The difference between Fig. 8A and Figs. 3G, 3G' is that the copper pillars 36 of Fig. 8A have a top surface coplanar with a top surface of the molding compound 37.
Fig. 8B is a modified embodiment of Figs. 4G, 4G'
The difference between Fig. 8B and Figs. 4G, 4G' is that the copper pillars 36 of Fig. 8B have a top surface coplanar with a top surface of the molding compound 37.

## Claims

1. A molding compound supported redistribution layer (RDL) structure for an integrated circuit (IC) package, the RDL structure comprising:
a molding compound (37, 372);
a plurality of copper pillars (36), each having a bottom end protruded below the molding compound (37, 372);
a bottom RDL (RDL1), configured on bottom of the molding compound (37, 372);
having a plurality of first bottom pads (341) and a plurality of first top pads (343); wherein
the density of the first bottom pads (341) is higher than the density of the first top pads (343); and wherein
the bottom end of each copper pillar (36) is electrically coupled to a corresponding first top pad (343).

2. A molding compound supported redistribution layer (RDL) structure for an integrated circuit (IC) package as claimed in claim 1, further comprising:
a top protection layer (361, 362), protecting a top end of a corresponding copper pillar (36).

3. A molding compound supported redistribution layer (RDL) structure for an integrated circuit (IC) package as claimed in claim 2, wherein the top protection layer (361, 362) is selected from a group consisting of ENEPIG and OSP.

4. A molding compound supported redistribution layer (RDL) structure for an integrated circuit (IC) package as claimed in claim 2, further comprising:
a plurality of solder balls (38), wherein each solder ball (38) is configured on a top surface of a corresponding top protection layer (361, 362).

5. A molding compound supported redistribution layer (RDL) structure for an integrated circuit (IC) package as claimed in claim 1, further comprising:
a plurality of solder balls (38), each configured on a top surface of a corresponding copper pillar (36).

6. A molding compound supported redistribution layer (RDL) structure for an integrated circuit (IC) package as claimed in claim 1, further comprising:
a bottom protection layer (39), configured on a bottom surface of a corresponding first bottom pad (341).

7. A molding compound supported redistribution layer (RDL) structure for an integrated circuit (IC) package as claimed in claim 6, wherein the bottom protection layer (39) is selected from a group consisting of ENEPIG and OSP.

8. A molding compound supported redistribution layer (RDL) structure for an integrated circuit (IC) package as claimed in claim 1, further comprising:
a top RDL (RDL2), configured on a top surface of the molding compound (37); having a plurality of second bottom pads (441) on bottom, and having a plurality of second top pads (443) on top; wherein the density of the plurality of second bottom pads (441) is higher than the density of the plurality of the second top pads (443); and wherein
a top end of each copper pillar (36) is electrically coupled to a corresponding second bottom pad (441).

9. A molding compound supported redistribution layer (RDL) structure for an integrated circuit (IC) package as claimed in claim 8, further comprising:
a plurality of solder balls (38), each configured on a top surface of a corresponding second top pad (443).

10. A molding compound supported redistribution layer (RDL) structure for an integrated circuit (IC) package as claimed in claim 1, comprising:
a central cavity (388), surrounded by the molding compound (372);
wherein the top pads (343) located in the central cavity (388) are adaptive for mounting at least one passive element (395).

11. A molding compound supported redistribution layer (RDL) structure for an integrated circuit (IC) package as claimed in claim 10, further comprising:
a top protection layer (361, 362), protecting a top end of a corresponding copper pillar (36).

12. A molding compound supported redistribution layer (RDL) structure for an integrated circuit (IC) package as claimed in claim 11, wherein the top protection layer (361, 362) is selected from a group consisting of ENEPIG and OSP.

13. A molding compound supported redistribution layer (RDL) structure for an integrated circuit (IC) package as claimed in claim 11, further comprising:
a plurality of solder balls (38), each configured on a top surface of a corresponding top protection layer (361, 362).

14. A molding compound supported redistribution layer (RDL) structure for an integrated circuit (IC) package, the RDL structure comprising:
a molding compound (57);
a plurality of copper pillars (56), each having a bottom end protruded below the molding compound (57);
a bottom RDL (RDL1), configured on bottom of the molding compound (57); having a plurality of bottom pads (542) and a plurality of top pads (541); wherein
the density of the bottom pads (542) is lower than the density of the top pads (541);
and wherein the bottom end of each copper pillar (58) is electrically coupled to a corresponding top pad (541).

15. A molding compound supported redistribution layer (RDL) structure for an integrated circuit (IC) package as claimed in claim 14, further comprising:
a chip (591), configured on a top surface of the plurality of copper pillars (56).

16. A molding compound supported redistribution layer (RDL) structure for an integrated circuit (IC) package as claimed in claim 15, further comprising:
a plurality of solder balls (58), each being configured on a bottom surface of a corresponding bottom pad (542).

## Patentansprüche

1. Formmassengestützte Umverteilungsschicht(RDL)-Struktur für ein Gehäuse einer integrierten Schaltung (IC), wobei die RDL-Struktur folgendes umfasst:
eine Formmasse (37, 372);
eine Vielzahl von Kupfersäulen (36), die jeweils ein unteres Ende aufweisen, das unterhalb der Formmasse (37, 372) vorspringt;
eine untere RDL (RDL1), die auf der Unterseite der Formmasse (37, 372) angeordnet ist und eine Vielzahl von ersten unteren Lötflächen (341) und eine Vielzahl von ersten oberen Lötflächen (343) aufweist, wobei
die Dichte der ersten unteren Lötflächen (341) höher ist als die Dichte der ersten oberen Lötflächen (343), und wobei
das untere Ende jeder Kupfersäule (36) elektrisch mit einer entsprechenden ersten oberen Lötfläche (343) verbunden ist.

2. Formmassengestützte Umverteilungsschicht(RDL)-Struktur für ein Gehäuse einer integrierten Schaltung (IC) nach Anspruch 1, ferner umfassend:
eine obere Schutzschicht (361, 362), die ein oberes Ende einer entsprechenden Kupfersäule (36) schützt.

3. Formmassengestützte Umverteilungsschicht(RDL)-Struktur für ein Gehäuse einer integrierten Schaltung (IC) nach Anspruch 2, wobei die obere Schutzschicht (361, 362) ausgewählt ist aus einer Gruppe bestehend aus ENEPIG und OSP.

4. Formmassengestützte Umverteilungsschicht(RDL)-Struktur für ein Gehäuse einer integrierten Schaltung (IC) nach Anspruch 2, ferner umfassend:
eine Vielzahl von Lötkugeln (38), wobei jede Lötkugel (38) auf einer oberen Oberfläche einer entsprechenden oberen Schutzschicht (361, 362) angeordnet ist.

5. Formmassengestützte Umverteilungsschicht(RDL)-Struktur für ein Gehäuse einer integrierten Schaltung (IC) nach Anspruch 1, ferner umfassend:
eine Vielzahl von Lötkugeln (38), die jeweils auf einer oberen Oberfläche einer entsprechenden Kupfersäule (36) angeordnet sind.

6. Formmassengestützte Umverteilungsschicht(RDL)-Struktur für ein Gehäuse einer integrierten Schaltung (IC) nach Anspruch 1, ferner umfassend:
eine untere Schutzschicht (39), die auf einer unteren Oberfläche einer entsprechenden ersten unteren Lötfläche (341) angeordnet ist.

7. Formmassengestützte Umverteilungsschicht(RDL)-Struktur für ein Gehäuse einer integrierten Schaltung (IC) nach Anspruch 6, wobei die untere Schutzschicht (39) ausgewählt ist aus einer Gruppe bestehend aus ENEPIG and OSP.

8. Formmassengestützte Umverteilungsschicht(RDL)-Struktur für ein Gehäuse einer integrierten Schaltung (IC) nach Anspruch 1, ferner umfassend:
eine obere RDL (RDL2), die auf einer oberen Oberfläche der Formmasse (37) angeordnet ist, und auf der Unterseite eine Vielzahl von zweiten unteren Lötflächen (441) und auf der Oberseite eine Vielzahl von zweiten oberen Lötflächen (443) aufweist,
wobei die Dichte der Vielzahl von zweiten unteren Lötflächen (441) höher ist als die Dichte der Vielzahl der zweiten oberen Lötflächen (443), und wobei
ein oberes Ende jeder Kupfersäule (36) elektrisch mit einer entsprechenden zweiten unteren Lötfläche (441) verbunden ist.

9. Formmassengestützte Umverteilungsschicht(RDL)-Struktur für ein Gehäuse einer integrierten Schaltung (IC) nach Anspruch 8, ferner umfassend:
eine Vielzahl von Lötkugeln (38), die jeweils auf einer oberen Oberfläche einer entsprechenden zweiten oberen Lötfläche (443) angeordnet sind.

10. Formmassengestützte Umverteilungsschicht(RDL)-Struktur für ein Gehäuse einer integrierten Schaltung (IC) nach Anspruch 1, umfassend:
eine von der Formmasse (372) umgebene zentrale Aussparung (388);
wobei die in der zentralen Aussparung (388) angeordneten oberen Lötflächen (343) zur Montage mindestens eines passiven Elements (395) verwendbar sind.

11. Formmassengestützte Umverteilungsschicht(RDL)-Struktur für ein Gehäuse einer integrierten Schaltung (IC) nach Anspruch 10, ferner umfassend:
eine obere Schutzschicht (361, 362), die ein oberes Ende einer entsprechenden Kupfersäule (36) schützt.

12. Formmassengestützte Umverteilungsschicht(RDL)-Struktur für ein Gehäuse einer integrierten Schaltung (IC) nach Anspruch 11, wobei die obere Schutzschicht (361, 362) ausgewählt ist aus einer Gruppe bestehend aus ENEPIG und OSP.

13. Formmassengestützte Umverteilungsschicht(RDL)-Struktur für ein Gehäuse einer integrierten Schaltung (IC) nach Anspruch 11, ferner umfassend:
eine Vielzahl von Lötkugeln (38), die jeweils auf einer oberen Oberfläche einer entsprechenden oberen Schutzschicht (361, 362) angeordnet sind.

14. Formmassengestützte Umverteilungsschicht(RDL)-Struktur für ein Gehäuse einer integrierten Schaltung (IC), wobei die RDL-Struktur folgendes umfasst:
eine Formmasse (57);
eine Vielzahl von Kupfersäulen (56), die jeweils ein unteres Ende aufweisen, das unterhalb der Formmasse (57) vorspringt;
eine untere RDL (RDL1), die auf der Unterseite der Formmasse (57) angeordnet ist und eine Vielzahl von unteren Lötflächen (542) und eine Vielzahl von oberen Lötflächen (541) aufweist, wobei
die Dichte der unteren Lötflächen (542) niedriger ist als die Dichte der oberen Lötflächen (541);
und wobei das untere Ende jeder Kupfersäule (58) elektrisch mit einer entsprechenden oberen Lötfläche (541) verbunden ist.

15. Formmassengestützte Umverteilungsschicht(RDL)-Struktur für ein Gehäuse einer integrierten Schaltung (IC) nach Anspruch 14, ferner umfassend:
einen Chip (591), der auf einer oberen Oberfläche der Vielzahl von Kupfersäulen (56) angeordnet ist.

16. Formmassengestützte Umverteilungsschicht(RDL)-Struktur für ein Gehäuse einer integrierten Schaltung (IC) nach Anspruch 15, ferner umfassend:
eine Vielzahl von Lötkugeln (58), die jeweils auf einer unteren Oberfläche einer entsprechenden unteren Lötfläche (542) angeordnet sind.

## Revendications

1. Structure de couche de redistribution supportée par un composé de moulage (RDL) pour un boîtier de circuit intégré (IC), la structure RDL comprenant:
un composé de moulage (37, 372);
une pluralité de piliers de cuivre (36) présentant chacun une extrémité inférieure faisant saillie en dessous du composé de moulage (37, 372);
une RDL inférieure (RDL1) configurée sur le dessous du composé de moulage (37, 372) et présentant une pluralité de premiers coussinets de dessous (341) et une pluralité de premiers coussinets du dessus (343), dans laquelle la densité des premiers coussinets de dessous (341) est supérieure à la densité des premiers coussinets du dessus (343), et dans laquelle
l'extrémité inférieure de chaque pilier de cuivre (36) est électriquement couplée à un premier coussinet du dessus (343) correspondant.

2. Structure de couche de redistribution supportée par un composé de moulage (RDL) pour un boîtier de circuit intégré (IC) selon la revendication 1, comprenant en outre:
une couche de protection supérieure (361, 362) protégeant une extrémité supérieure d'un pilier de cuivre (36) correspondant.

3. Structure de couche de redistribution supportée par un composé de moulage (RDL) pour un boîtier de circuit intégré (IC) selon la revendication 2, dans laquelle la couche de protection supérieure (361, 362) est choisie parmi un groupe comprenant l'ENEPIG et l'OSP.

4. Structure de couche de redistribution supportée par un composé de moulage (RDL) pour un boîtier de circuit intégré (IC) selon la revendication 2, comprenant en outre:
une pluralité de billes de soudure (38), où chaque bille de soudure (38) est configurée sur une surface supérieure d'une couche de protection supérieure (361, 362) correspondante.

5. Structure de couche de redistribution supportée par un composé de moulage (RDL) pour un boîtier de circuit intégré (IC) selon la revendication 1, comprenant en outre:
une pluralité de billes de soudure (38), respectivement configurées sur une surface supérieure d'un pilier de cuivre (36) correspondant.

6. Structure de couche de redistribution supportée par un composé de moulage (RDL) pour un boîtier de circuit intégré (IC) selon la revendication 1, comprenant en outre:
une couche de protection inférieure (39) configurée sur une surface inférieure d'un premier coussinet de dessous (341) correspondant.

7. Structure de couche de redistribution supportée par un composé de moulage (RDL) pour un boîtier de circuit intégré (IC) selon la revendication 6, dans laquelle la couche de protection inférieure (39) est choisie parmi un groupe comprenant l'ENEPIG et l'OSP.

8. Structure de couche de redistribution supportée par un composé de moulage (RDL) pour un boîtier de circuit intégré (IC) selon la revendication 1, comprenant en outre:
une RDL supérieure (RDL2) configurée sur une surface supérieure du composé de moulage (37, 372), et présentant une pluralité de deuxièmes coussinets de dessous (441) sur le dessous, et présentant une pluralité de deuxièmes coussinets du dessus (443) sur le dessus, la densité de la pluralité de deuxièmes coussinets de dessous (441) étant supérieure à la densité de la pluralité de deuxièmes coussinets du dessus (443), et dans laquelle
une extrémité supérieure de chaque pilier de cuivre (36) est électriquement couplée à un deuxième coussinet de dessous (441) correspondant.

9. Structure de couche de redistribution supportée par un composé de moulage (RDL) pour un boîtier de circuit intégré (IC) selon la revendication 8, comprenant en outre:
une pluralité de billes de soudure (38) respectivement configurées sur un deuxième coussinet du dessus (443) correspondant.

10. Structure de couche de redistribution supportée par un composé de moulage (RDL) pour un boîtier de circuit intégré (IC) selon la revendication 1, comprenant:
une cavité centrale (388) entourée par le composé de moulage (372);
dans laquelle les coussinets du dessus (343) situés dans la cavité centrale (388) sont adaptés pour le montage d'au moins un élément passif (395).

11. Structure de couche de redistribution supportée par un composé de moulage (RDL) pour un boîtier de circuit intégré (IC) selon la revendication 10, comprenant en outre:
une couche de protection supérieure (361, 362) protégeant une extrémité supérieure d'un pilier de cuivre (36) correspondant.

12. Structure de couche de redistribution supportée par un composé de moulage (RDL) pour un boîtier de circuit intégré (IC) selon la revendication 11, dans laquelle la couche de protection supérieure (361, 362) est choisie parmi un groupe comprenant l'ENEPIG et l'OSP.

13. Structure de couche de redistribution supportée par un composé de moulage (RDL) pour un boîtier de circuit intégré (IC) selon la revendication 11, comprenant en outre:
une pluralité de billes de soudure (38) respectivement configurées sur une surface supérieure d'une couche de protection supérieure (361, 362) correspondante.

14. Structure de couche de redistribution supportée par un composé de moulage (RDL) pour un boîtier de circuit intégré (IC), la structure RDL comprenant:
un composé de moulage (57);
une pluralité de piliers de cuivre (56) présentant chacun une extrémité inférieure faisant saillie en dessous du composé de moulage (57);
une RDL inférieure (RDL1) configurée sur le dessous du composé de moulage (57) ;
présentant une pluralité de coussinets de dessous (542) et une pluralité de coussinets du dessus (541), dans laquelle
la densité des coussinets de dessous (542) est supérieure à la densité des coussinets du dessus (541);
et dans laquelle l'extrémité inférieure de chaque pilier de cuivre (58) est électriquement couplée à un coussinet du dessus (541) correspondant.

15. Structure de couche de redistribution supportée par un composé de moulage (RDL) pour un boîtier de circuit intégré (IC) selon la revendication 14, comprenant en outre:
une puce (591) configurée sur une surface supérieure de la pluralité de piliers de cuivre (56).

16. Structure de couche de redistribution supportée par un composé de moulage (RDL) pour un boîtier de circuit intégré (IC) selon la revendication 15, comprenant en outre:
une pluralité de billes de soudure (58) respectivement configurées sur une surface inférieure d'un coussinet de dessous (542) correspondant.
